# EUROPEAN PATENT APPLICATION

(11) **EP 1 553 629 A2**
(43) Date of publication of application: **13.07.2005**
(21) Application number: 05000127.0
(22) Date of filing: 05.01.2005
(51) Int. Cl.: H01L 23/48

(54) **Electrically conductive adhesive sheet, method of manufacturing the same, and electric power conversion equipment**

(30) Priority: 06.01.2004 JP 2004000734
(71) Applicant: Hitachi, Ltd., Tokyo 100-8280 (JP)
(72) Inventor: Suwa, Tokihito Hitachi, Ltd., Chiyoda-ku Tokyo 100-8220 (JP); Shigeta, Satoru Hitachi, Ltd., Chiyoda-ku Tokyo 100-8220 (JP); Shirakawa, Shinji Hitachi, Ltd., Chiyoda-ku Tokyo 100-8220 (JP); Ochiai, Yoshitaka Hitachi, Ltd., Chiyoda-ku Tokyo 100-8220 (JP)
(74) Representative: Beetz & Partner Patentanwälte

(57) **Abstract**

In order to solve the issue mentioned above, the present invention is featured in electrically conductive adhesive sheet: wherein the substrate 1 which composes electrically, thermally, or electrically and thermally conducting paths in a direction along the plane of the sheet is formed of metallic foil having a coefficient of thermal expansion between the coefficient of thermal expansion of one of at least two bonded members and the coefficient of thermal expansion of another one of the bonded members.

In accordance with the present invention adopting the composition mentioned above, a stress applied to the protrusion layer 2, which composes electrically, thermally, or both electrically and thermally conducting paths between the substrate 1 and the bonded members by difference in thermal expansion, can be moderated.

## Description

### CLAIM OF PRIORITY

The present application claims priority from Japanese application serial no. 2004-000734, filed on January 6 , 2004, the content of which is hereby incorporated by reference into this application.

### Background of the Invention

The present invention relates to electrically conductive adhesive sheet, a method of manufacturing the same, and an electric power conversion equipment.

As for a bonding member of semiconductor element with electrically conductive member, for instance, sheet members disclosed in the following Japanese Laid-open Patent Publication JP-A-6-291226(1994) and Japanese Laid-open Patent Publication JP-2003-273294(2003) are known. The sheet member disclosed in Japanese Laid-open Patent Publication JP-A-6-291226(1994) is manufactured by cladding a metallic foil with resin wherein metallic particles are dispersed. The sheet member disclosed in Japanese Laid-open Patent Publication JP-2003-273294(2003) is manufactured by providing plural metallic protrusions on one side or both sides of metallic foil, and then, filling a resin composition among gaps of the metallic protrusions.

### Summary of the invention

In electronics equipment using semiconductor elements, for instance, such as an electric power conversion equipment provided on vehicle for converting direct current power supplied from a battery mounted on the vehicle to alternate current power and supplying to motor, soldering is used for bonding the semiconductor elements with electrically conductive pattern formed on insulated substrate. Also, Aluminum wire is used for bonding electrically semiconductor elements with terminal members, and terminal members with electrically conductive pattern formed on insulated substrate. However, solder contains lead which is regarded to give influence to global environment.

Therefore, currently, use of lead-free solder and bonding members which replace solder for bonding semiconductor elements with electrically conductive pattern formed on substrate in electric power conversion equipment have been investigated. Bonding using aluminum wire has come to have a limit in accordance with increasing current density accompanied with grade up of the semiconductor element. Therefore, currently, bonding methods which replace aluminum wire have come to be investigated on electric power conversion equipment.

In connection with an electric power conversion equipment, it is necessary to keep temperature of semiconductor element within a range of allowable temperature. Accordingly, as for the bonding member suitable for the electric power conversion equipment, any bonding member having a large thermal conductivity is preferable. Furthermore, thermal fatigue is generated in the electric power conversion equipment in accordance with heat generation accompanied with operation of the semiconductor element or installation environment of the equipment. Thermal fatigue becomes particularly large at connecting boundaries of the semiconductor element with bonding member, and of the electrically conductive member with bonding member. Because, a large stress is applied onto the bonding boundary on account of large difference in thermal expansion generated by large difference in coefficients of thermal expansion of the semiconductor element, electrically conductive member, and the bonding member. Accordingly, as for the bonding member suitable for the electric power conversion equipment, any bonding member having a function to moderate the stress generated by the difference of thermal expansion is preferable.

The sheet member disclosed in the patent documents 1 and 2 described previously is one of the examples of the bonding member which can replace conventional bonding member.

However, in case of the sheet member disclosed in Japanese Laid-open Patent Publication JP-A-6-291226(1994), the metallic particle must break through the resin layer existing among the metallic particles in order to contact with the semiconductor element and the electrically conductive member. Furthermore, in case of the sheet member disclosed in Japanese Laid-open Patent Publication JP-A-6-291226(1994), electrically conductive paths in a thickness direction of the sheet are formed by making the metallic particles to contact each other at points in the thickness direction of the sheet, and a number of contact points equivalent to the number of metallic particles are formed inside the sheet.

Therefore, in case of the sheet member disclosed in Japanese Laid-open Patent Publication JP-A-6-291226(1994), the volume resistivity of the sheet is increased higher about one order than that of the metallic particle itself, and thermal resistance is increased. Accordingly, in case of using the sheet member disclosed in Japanese Laid-open Patent Publication JP-A-6-291226(1994) as bonding member, it is necessary to improve electric characteristics and to increase thermal conductivity.

Because the sheet member disclosed in Japanese Laid-open Patent Publication JP-A-6-291226(1994) is composed of a resin having a modulus of elasticity smaller than the modulus of elasticity of the semiconductor element and the electrically conductive member, it is possible to make the sheet member have a function to moderate the stress generated by difference of thermal expansion. However, the coefficient of thermal expansion of the resin is relatively large.

Therefore, in accordance with the sheet member disclosed in Japanese Laid-open patent Publication JP-A-6-291226(1994), contact resistance between the metallic particles is gradually increased with thermal expansion of the resin. Accordingly, when the sheet member disclosed in Japanese laid-open Patent Publication JP-A-6-291226(1994) is used as a bonding member, it is necessary to improve contact reliability.

On the other hand, in case of the sheet member disclosed in Japanese Laid-open Patent Publication JP-2003-273294(2003), the electrically conductive paths in a direction of thickness of the sheet are formedwithmetallic protrusion, and no contact points are formed inside the sheet. Therefore, in accordance with the sheet member disclosed in Japanese Laid-open Patent Publication JP-2003-273294(2003), the a volume resistance becomes lower than that of the sheet member disclosed in Japanese Laid-open Patent Publication JP-A-6-291226(1994), and thermal resistance also becomes lower than that of the sheet member disclosed in Japanese Laid-open Patent Publication JP-A-6-291226(1994).

Furthermore, because any contact point is not formed inside the sheet of the sheet member disclosed in Japanese Laid-open Patent Publication JP-2003-273294(2003), such problem as increase in contact resistance of the sheet member disclosed in Japanese Laid-open Patent Publication JP-A-6-291226(1994)is not generated.

Then, the inventors of the present invention directed their attention to the sheet member disclosed in Japanese Laid-open Patent Publication JP-2003-273294(2003) , and tried to apply the sheet member disclosed in Japanese Laid-open Patent Publication JP-2003-273294(2003) to an electric power conversion equipment. However, in accordance with the sheet member disclosed in Japanese Laid-open Patent Publication JP-2003-273294(2003), a stress generated by the difference of thermal expansion according to the difference of coefficients of thermal expansion and applied to the metallic protrusion , particularly the stress applied to the metallic protrusion bonding the semiconductor element with the metallic foil becomes significant. This is, because the coefficient of thermal expansion of the semiconductor element is 2∼4X10⁻⁶/K, while the coefficient of thermal expansion of the metallic foil (copper) is 17∼25X10⁻⁶/K as same as electrically conductive material.

Furthermore, because, different from electric power conversion equipment for industries and electric power conversion equipment for home appliance, the electric power conversion equipment for vehicle is used under a severer environment such as a thermal cycle from a low temperature as -40 °C to a high temperature as 130∼180 °C. Furthermore, because, in connection with the electric power conversion equipment for vehicle, low voltage system accompanied with grade up of power source mounted on vehicle is adopted currently, and current flown in the semiconductor element becomes large and heat generation of the semiconductor element is increased.

Accordingly, when applying the sheet member having metallic protrusion to the electric power conversion equipment for vehicle, it is necessary to moderate the stress which is generated by the difference of thermal expansion, and to improve contact reliability more than ever. Particularly, this is indispensable problem to be solved for the bonding member applied to the electric power conversion equipment for vehicle which is required to have a product life of more than 15 years.

The present invention provides an electrically conductive adhesive sheet which can be improved in contact reliability better than hitherto attained. Furthermore, the present invention provides electrically a conductive adhesive sheet which can maintain preferable contact reliability for a long time even if it is used as a bonding member in an equipment under severe thermal cycle condition, and can contribute to long life extension of the equipment.

The electrically conductive adhesive sheet relating to the present invention is featured in a substrate, wherein electrically, thermally, or both electrically and thermally conductive paths in a direction along a plane of the sheet is formed of metallic foil which has a coefficient of thermal expansion between the coefficient of thermal expansion of one of at least two bonded members and the coefficient of thermal expansion of another one of the bonded members.

In accordance with the present invention, because the substrate is composed as described above, a stress applied to metallic member which forms electrically conductive paths, thermally conductive paths, or both electrically and thermally conductive paths between the substrate and the bonding member generated by difference in their thermal expansion can be moderated.

Furthermore, the present invention provides a method of manufacturing an improved electrically conductive adhesive sheet.

Furthermore, the present invention provides an electric power conversion equipment for a vehicle, which is provided with the electrically conductive adhesive sheet described above as a bonding member.

In accordance with the present invention, the stress generated by difference in thermal expansion can be moderated as described above, and contact reliability can be improved more than ever. Accordingly, in accordance with the present invention, the electrically conductive adhesive sheet which can maintain preferable contact reliability for a long time even if it is used as a bonding member in an equipment under severe thermal cycle condition, and can contribute to long life extension of the equipment.

### Brief explanation of the drawings

FIG. 1 is a cross section showing the composition of the electrically conductive adhesive sheet of the embodiment 1 of the present invention;
FIG. 2 is a cross section showing the composition of the electrically conductive adhesive sheet of the embodiment 1 of the present invention;
   FIG. 3 is a cross section showing the module composition of inverter bridge circuit of the inverter equipment for vehicle, to which the electrically conductive adhesive sheet showing in FIG. 1 and FIG. 2 is applied as a bonding member;
FIG. 4 is a cross section showing the module composition of inverter bridge circuit of the inversion equipment for vehicle, to which the electrically conductive adhesive sheet showing in FIG. 1 and FIG. 2 is applied as a bonding member;
FIG. 5 is a drawing of system composition showing the electrical composition of an electric machine system for vehicle, in which the inverter equipment for vehicle shown in FIG. 3 and FIG. 4 is mounted.
FIG. 6 is a block diagram showing the composition of power train of vehicle, in which the inverter equipment for vehicle shown in FIG. 3 and FIG. 4 is mounted;
FIG. 7is a cross section showing a modified example of the electrically conductive adhesive sheet shown in FIG. 2;
FIG. 8 is a cross section showing a relationship of positions of the protrusion layer and the resin composition in the electrically conductive adhesive sheet shown in FIG. 1;
FIG. 9 is a cross section showing a modified example of the electrically conductive adhesive sheet shown in FIG. 8;
FIG. 10 is a cross section showing a modified example of the electrically conductive adhesive sheet shown in FIG. 8; and
FIG. 11 is a cross section showing the composition of the electrically conductive adhesive sheet of the embodiment 4 of the present invention.

### Detailed description of the preferred embodiments

The representative best mode embodiment of the electrically conductive adhesive sheet relating to the present invention is as follows. That is, the electrically conductive adhesive sheet, wherein at least two bonding members having different coefficient of thermal expansion each other are adhered, and these members are bonded electrically, thermally, or both electrically and thermally; the sheet comprises a substrate, a protrusion layer formed on one side or both sides of the substrate, and a resin composition filled into the protrusion layer; the substrate is composed of metallic foil, which forms electrically, thermally, or both electrically and thermally path in a direction along the plane of the sheet, having a coefficient of thermal expansion between the coefficient of thermal expansion of one of the at least two bonded members and the coefficient of thermal expansion of another one of the bonded members; the protrusion layer is provided with plural metallic columns, which form electrically, thermally, or both electrically and thermally paths between one of the at least two bonded members and the substrate; the plural metallic columns is provided onto the surface of the substrate so that top of the metallic columns are exposed outside from the resin composition; the resin composition adheres at least two bonded members in a condition that the at least two bonded members are contacted by bonding each other.

One of the representative best mode embodiments of the method of manufacturing electrically conductive adhesive sheet relating to the present invention is as follows. That is, the method of manufacturing electrically conductive adhesive sheet comprises:
a step for manufacturing a substrate by cladding both sides of a second metallic material having a coefficient of thermal expansion smaller than that of a first metallic material with a first metallic material having a volume resistivity smaller than that of the second metallic material;
a step for forming a resin layer on one side or both sides of the substrate;
a step for boring plural holes into the resin layer with a designated pitch; and
a step for forming a protrusion layer onto one side or both sides of the substrate by plating the plural holes to form plural metallic columns on the surface of the substrate so that top of the metallic columns are exposed outside from the resin layer.

Another representative best mode embodiment of the method of manufacturing electrically conductive adhesive sheet relating to the present invention is as follows. That is, the method of manufacturing electrically conductive adhesive sheet comprises:
a step for manufacturing a substrate by cladding both sides of a second metallic material having a coefficient of thermal expansion smaller than that of a first metallic material with a first metallic material having a volume resistivity smaller than that of the second member;
a step for adhering a pattern member for plating onto a surface or both sides of the substrate;
a step for boring plural holes into the pattern member for plating with a designated pitch;
a step for forming a protrusion layer onto one side or both sides of the substrate by plating the plural holes and peeling off the pattern member to form plural metallic columns on one side or both sides of the substrate;
a step for forming a resin layer onto one side or both sides of the substrate by filling a resin composition into the protrusion layer; and
a step for manufacturing surface of the resin layer so that top of the metallic columns are exposed outside from the resin layer.

The representative best mode embodiments of the electric power conversion equipment relating to the present invention is as follows. That is, the electric power conversion equipment supplying electric power to a motor after converting direct current power supplied from a battery to alternate current power so as to control motor driving, which comprises: a heat sink cooled by cooling medium; an insulated substrate mounted on the heat sink; plural semiconductor elements mounted on the insulated substrate; plural electrically conductive members at input side which receive output from a battery mounted on vehicle; and plural electrically conductive members at output side which receive output from the semiconductor elements; in which: plural semiconductor elements compose plural upper-side arm semiconductor elements and plural lower-side arm semiconductor elements; the plural upper-side arm semiconductor elements and the plural lower-side arm semiconductor elements are connected electrically in a bridge shape so as to form a bridge circuit for converting direct current power supplied from a battery mounted on vehicle to alternate current power; plural electrically conductive patterns are provided at both sides of the insulated substrate; and electrically conductive sheet is used at least for connecting said plural upper-side arm semiconductor elements with said electrically conductive pattern which corresponds to each of said plural upper-side arm semiconductor elements, and for connecting said plural lower-side arm semiconductor elements with said electrically conductive pattern which corresponds to each of said plural lower-side arm semiconductor elements, respectively; said electrically conductive sheet comprises: a substrate; a protrusion layer formed at any of both sides and a surface of the substrate; and resin composition filled into said protrusion layer; the substrate is made of metallic foil, forming electrically and thermally conductive path in a direction along the surface of the sheet, having a coefficient of thermal expansion of a value between the coefficients of thermal expansion of the electrically conductive pattern corresponding to each of the plural upper-side arm semiconductor elements, or the coefficients of thermal expansion of the electrically conductive pattern corresponding to each of the plural lower-side arm semiconductor elements, and the coefficients of thermal expansion of the semiconductor element; the protrusion layer is provided with plural metallic columns forming electrically and thermally conductive paths between the substrate and the electrically conductive pattern corresponding to each of the plural upper-side arm semiconductor elements, between the substrate and the electrically conductive pattern corresponding to each of the plural lower-side arm semiconductor elements, and between the plural semiconductor elements and the substrate; the plural metallic columns are provided at surface of the substrate so that the top of the metallic column is exposed outside from surface of the resin composition; and the resin composition adheres the electrically conductive pattern corresponding to each of the plural upper-side arm semiconductor elements, the electrically conductive pattern corresponding to each of the plural lower-side arm semiconductor elements, and the semiconductor elements each other in a condition that the plural metallic columns are contacted with the electrically conductive pattern corresponding to each of the plural upper-side arm semiconductor elements, the electrically conductive pattern corresponding to each of said plural lower-side arm semiconductor elements, and the semiconductor elements, to connect the plural upper-side arm semiconductor elements to the electrically conductive pattern corresponding to each of the upper-side arm semiconductor elements, and the plural lower-side arm semiconductor elements to the electrically conductive pattern corresponding to each of the lower-side arm semiconductor elements each other.

### [Embodiment 1]

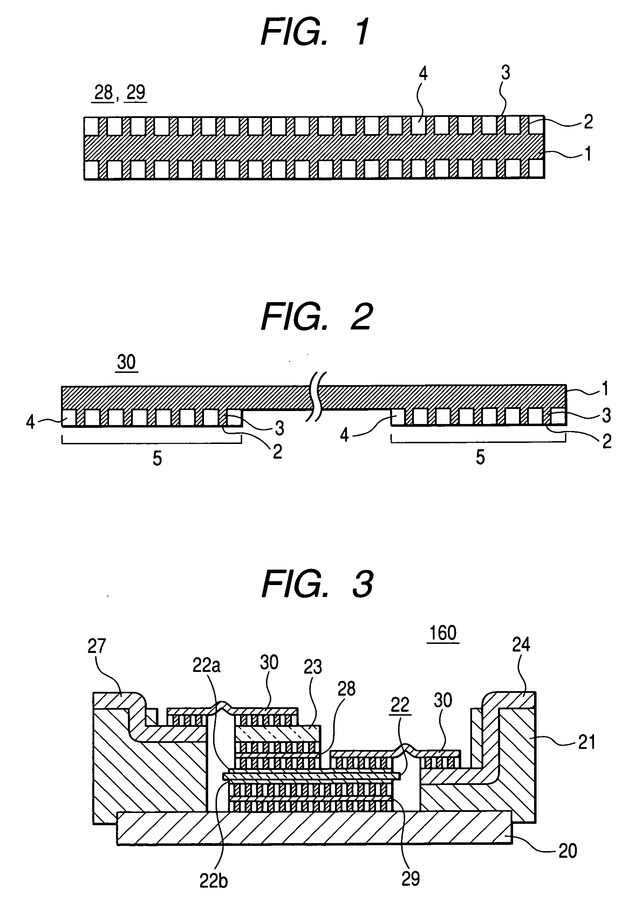

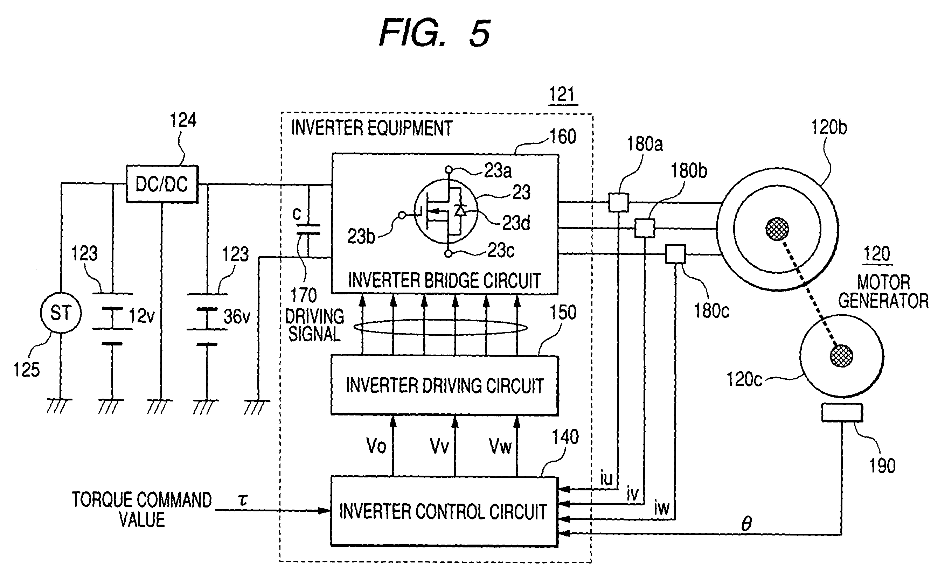

The embodiment 1 of the present invention is explained hereinafter referring to figure 1 to figure 6.

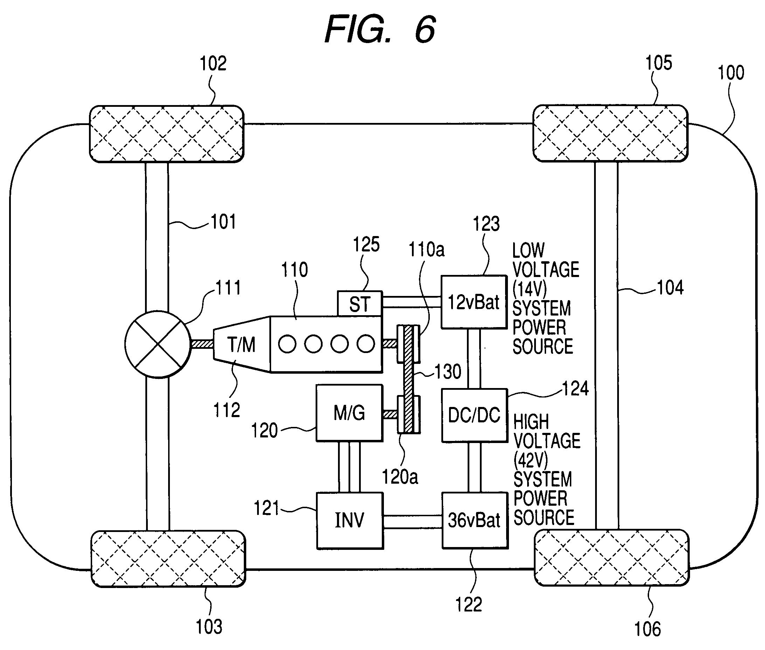

The electrically conductive adhesive sheet of the present embodiment showing in FIG. 1 and FIG. 2 are applied to the electric power conversion equipment showing in FIG. 3 to FIG. 5 as a bonding member. The electric power conversion equipment showing in FIG. 3 to FIG. 5 is mounted on a vehicle showing in FIG. 6. The electrically conductive adhesive sheet relating to the present embodiment is particularly useful as a bonding member of electric conversion equipment for vehicle which has severe thermal cycles, but it can be applied to also electric power conversion equipment for industries or home appliance, and other semiconductor devices as a bonding member which can replace solder and wire.

First, an outline of the power train composition of the vehicle showing in FIG. 6 is explained hereinafter. The vehicle showing in FIG. 6 is one of hybrid electric vehicles which is provided with both an engine power train having an internal combustion engine 110 as a power source and an electric power train having a motor generator 120 as another power source. The engine power train composes mainly driving power source of the vehicle. The electric power train is used mainly as a starting power source of the engine 110, an assistant power source of the engine 110, and an electric source of the vehicle.

Accordingly, in accordance with the vehicle shown in FIG. 6, the engine 110 can be stopped when the vehicle is stopped such as at red traffic light with ignition key is in a position of ON, and the engine 110 can be started again when the vehicle resumes running, that is, so-called idle stop can be realized.

In accordance with the vehicle shown in FIG. 6, the article 100 is the body of the vehicle. Front wheel axis 101 is supported in a rotatable manner at the front portion of the body 100. Front wheels 102, 103 are provided at both ends of the front wheel axis 101. Rear wheel axis 104 is supported in a rotatable manner at the rear portion of the body 100. Rear wheels 102, 103 are provided at both ends of the rear wheel axis 104. The vehicle shown in FIG. 6 uses a front wheel drive system. Therefore, a differential gear 111 (hereinafter, called shortly as DEF111), a driving force distributor, is provided at the middle of the front wheel axis 101, and the rotating driving force transmitted from the engine 110 through the transmission 112 is distributed to front wheel axis 101 of left side wheel and right side wheel. The transmission 112 shifts and transmits the rotating driving force of the engine 110 to DEF111.

The motor generator 120 is connected mechanically to the engine 110. Accordingly, the rotation driving force of the motor generator 120 can be transmitted to the engine 110, and the rotation driving force of the engine 110 can be transmitted to the motor generator, respectively. In accordance with the vehicle shown in FIG. 6, the engine 110 and the motor generator 120 is connected mechanically by connecting mechanically a pulley 110a provided at crank shaft of the engine 110 and the pulley 120a provided at rotating shaft of the motor generator 120 with a belt 130.

The motor generator 120 generates a rotation driving force corresponding to three phase alternate current power which is controlled by the inverter 121 and supplied to the stator coil (figure is omitted) of the stator 120b to rotate the rotor 120c having magnets (figure is omitted). That means, the motor generator 120 is controlled by the inverter 121, and operates as a motor. On the other hand, the motor generator 120 generates three phase alternate current power by rotating the rotor 120c with receiving a rotation driving force from the engine 110 and inducing an electromotive force in the stator coil of the stator 120b. That means, the motor generator 120 operates as a electric power generator. In the present embodiment, an alternate current synchronous motor generator, of which rotor 120c has magnets, is taken as an example for the explanation, but an alternate current induction motor generator may also be usable.

The inverter 121 is an electric power conversion equipment for converting a direct current power supplied from a high voltage battery 122 to a three phase alternate current power, and the inverter drives (On and OFF) a semiconductor element for electric power conversion, which composes an inverter circuit, corresponding to driving signals which are generated according to command signals, the command signals are calculated corresponding to input signals such as operation command, the value of three phase alternate current flown in the stator coils of the motor generator 120, positions of magnetic poles, and so on. The high voltage battery 122 composes a high voltage system (42 V) power source of the vehicle shown in FIG. 6, and the high voltage power is used as a driving power source of the motor generator 120, a power source of actuator for injector (fuel injecting valve) which controls the amount of fuel supplied to the engine 110, a power source of actuator for throttle valve (restrictor) which controls the amount of air supplied to the engine 110, and so on. Three phase alternate current power generated by the motor generator 120 is converted to direct current power by the inverter 121, and is supplied to the high voltage battery 122. The high voltage battery 122 is charged with converted direct current electric power. As for the high voltage battery 122, a lithium-ion battery, of which battery voltage is 36 Volts, is used.

The high voltage battery 122 is connected electrically to a low voltage battery 123 via a DC-DC converter 124. The low voltage battery composes a low voltage system (14 V) power source of the vehicle shown in FIG. 6, and the low voltage power is used as an electric power source of starter for starting the engine, and as electric power sources of radio, light, and so on. Direct current power from the high voltage battery 122 is lowered its voltage by the DC-DC converter 124, and supplied to the low voltage battery 123. The low voltage battery is charged with voltage-lowered direct current power. Furthermore, the direct current power from the low voltage battery 123 can be increased its voltage by the DC-DC converter 124, and supplied to the high voltage battery 122 for charging the high voltage battery 122. As for the low voltage battery 123, a lead battery, of which battery voltage is 12 Volts, is used.

The vehicle shown in FIG. 6 has plural driving modes, and electric power train driving is controlled corresponding to each of the driving modes. When the engine 110 is in an initial starting mode, that is, the engine 110 is in a cold condition, and ignition key switch is operated to be ON for starting the engine 110, that is, the engine is started at the cold condition, a direct current power is supplied to the starter 125 from the low voltage battery 123 for driving the starter 125. Then, the engine 110 can be started.

When the engine 110 is in an re-starting mode (idle stop mode), that is, the engine 110 is in a warm condition, the ignition key switch is in an ON condition, the engine 110 is stopped for stopping the vehicle by such as waiting change of red traffic light and the like, and the engine 110 is re-started (hot starting) for driving the vehicle, a direct current power from the high voltage battery 122 is supplied to the motor generator 120 for driving the motor generator 120 after converting the direct current to an alternate current power by the inverter 121, and a rotation driving force of the motor generator is transmitted to the engine 110. Then the engine 110 is re-started. When in the idle stop mode, if charging amount of the battery is insufficient, or the engine 110 is not warmed up sufficiently, and the like, the engine 110 is not stopped and driving is maintained. During the idle stop mode, a driving power source for auxiliary equipments such as compressor of air conditioner and the like, of which driving power source is the engine 110, must be ensured. In this case, the motor generator 120 is operated for driving the auxiliary equipments.

Because a load onto the engine 110 is increased during the time in an acceleration mode or a high load driving mode, the direct current power from the high voltage battery 122 is converted to an alternate current power by the inverter 121, the alternate current power is supplied to the motor generator 120 for driving the motor generator 120, and the rotation driving force of the motor generator 120 is transmitted to the engine 110. Accordingly, driving the motor 110 is assisted. When the high voltage battery is in a charging mode, in which charging the high voltage battery 122 is necessary, the motor generator 120 is driven by the engine 110. Accordingly, an alternate current power is generated, the generated power is converted to a direct current power by the inverter 121, and the direct current power is used for charging the high voltage battery 122. When the vehicle is in a regeneration mode such as braking or deceleration, a motion energy of the vehicle is transmitted to the motor generator 120 to drive the motor generator 120. Accordingly, an alternate current is generated, and the generated power is converted to a direct current power by the inverter 121 and is used for charging the high voltage battery 122.

Next, composition of the inverter 112 shown in FIG. 3 to FIG. 6 is explained hereinafter.

The inverter 112 is composed of roughly the inverter control circuit 140, the inverter driving circuit 150, and the inverter bridge circuit 160. The inverter control circuit 140 receives a torque command τ which is output from a higher level controller such as hybrid controller or engine controller, a current value iu∼iw of u-phase∼ w-phase detected by the current sensor 180a∼180c, and a position of magnetic pole θ of the rotor 120c detected by the magnetic pole position sensor 190, as input signals; calculation is performed based on the input signals; and voltage commands vv∼vw are output to the inverter driving circuit 150. The inverter driving circuit 150 generates driving signals of semiconductor element 23 based on the voltage commands vv∼vw output from the inverter control circuit 140, and outputs the generated driving signals to the inverter bridge circuit 160. The inverter bridge circuit 160 drives (ON/OFF operation) the power semiconductor element 23 based on the driving signals which are output from the inverter driving circuit 150, and converts the direct current power supplied from the high voltage battery 122 to three phase alternate current and supplies to stator coils of the stator 120b of the motor generator 120.

The inverter bridge circuit 160 is composed of six power semiconductor elements 23 which are connected electrically to form bridges, and forms a semiconductor module. In accordance with the present embodiment, MOSFET (Metal Oxide Semiconductor Field-Effect transistor) is used as the power semiconductor element 23. IGBT (Insulated Gate type Bipolar Transistor) may also be used instead of MOSFET. The power semiconductor element composed of MOSFET is provided with three electrodes, such as drain electrode 23a, source electrode 23c, and gate electrode 23b which inputs driving signals output from the inverter driving circuit 150. The power semiconductor element 23 composed of MOSFET is provided with diode 23d which is connected electrically between the drain electrode 23a and the source electrode 23c. Forward direction of the diode 23d is directed in a direction from the source electrode 23c to the drain electrode 23a.

The bridge circuit is composed of three arm circuit which are arranged in parallel, each of the arm circuit is composed by connecting electrically in series the source electrode 23c of the power semiconductor element 23 at upper arm side to the drain electrode 23a of the power semiconductor element 23 at lower arm side, and the drain electrode 23a and the positive side pole of the direct current of the power semiconductor element 23 at upper arm side of each arm are connected electrically to the source electrode 23c and the negative side pole of the direct current of the power semiconductor element 23 at lower arm side of each arm. The u-phase side of the alternate current is connected electrically between the source electrode 23c of the power semiconductor element 23 at upper arm side and the drain electrode 23a of the power semiconductor element 23 at lower arm side of the first arm circuit. The v-phase side of the alternate current is connected electrically between the source electrode 23c of the power semiconductor element 23 at upper arm side and the drain electrode 23a of the power semiconductor element 23 at lower arm side of the second arm circuit. The w-phase side of the alternate current is connected electrically between the source electrode 23c of the power semiconductor element 23 at upper arm side and the drain electrode 23a of the power semiconductor element 23 at lower arm side of the third arm circuit. A smoothing capacitance 170 for control fluctuation of the direct current caused by operation of the power semiconductor element 23 is connected electrically between the direct current positive side pole and the negative side pole of the inverter bridge circuit 160.

Next, composition of practical inverter bridge circuit, that is, composition of semiconductor module is explained hereinafter.

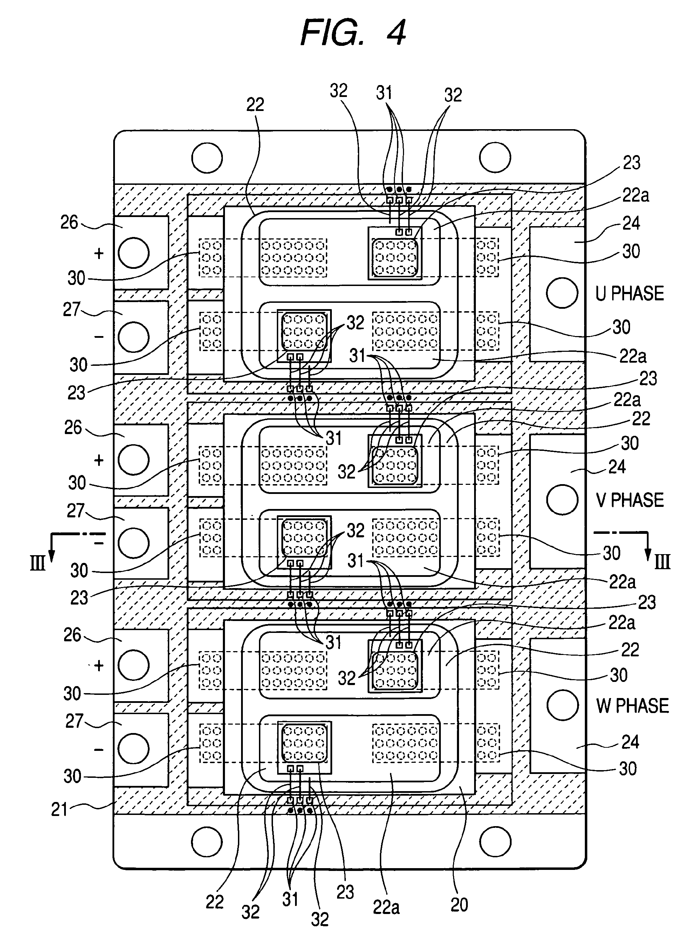

The reference number 20 in FIG. 3 and FIG. 4 indicates a heat radiation plate made of oxygen free copper plated with nickel. The heat radiation plate 20 is heat conductive, and cooled with cooling medium such as air, water, anti-freeze liquid, and the like. A circumference wall of the case 21, of which top and bottom are open, is provided at peripheral portion of the heat radiation plate 20. The case 21 is fabricated with a resin having insulating property, and the like. Inner portion of the case is partitioned corresponding to each of the arm in the bridge circuit. A pair of the direct current positive pole terminal 26 and the direct current negative pole terminal 27 is provided onto one of side walls, which are facing each other, of the case 21 by insert-fabrication. The direct current positive pole terminal 26 and the direct current negative pole terminal 27 are formed from an electrically conductive plate member; one of which is exposed outside from the outer surface of one of the mutually facing side walls of the case 21, and another one is exposed to inner portion of the case 21 by extending through inner portion of one of the mutually facing side walls, which forms a stepwise shape. The alternate current terminal 24 is provided into each of the partitions of another one of the mutually facing side walls of the case 21 by insert-fabrication. The alternate current terminal 24 is formed from an electrically conductive plate member; one of which is exposed outside from the outer surface of one of the mutually facing side walls of the case 21, and another one is exposed to inner portion of the case 21 by extending through inner portion of one of the mutually facing side walls, which forms a stepwise shape.

The insulation substrate 22 is provided at each of the partitions on the heat radiation plate 20 in the case 21. The insulation substrate 22 is made of ceramics, and conductive patterns 22a, 22b are formed on its both sides bymetallizing. The conductive pattern 22b is adhered onto the heat radiation plate 20 with electrically conductive adhesive sheet 29. Accordingly, the conductive pattern 22b is bonded thermally to the heat radiation plate 23. The power semiconductor element 23 is bonded to the portion of the direct current negative pole terminal 27 of the conductive pattern 22a at each partition in the case 21 with electrically conductive adhesive sheet 28. The power semiconductor element 23 is bonded to another portion of the alternate current terminal 24 of the conductive pattern 22a (the portion is located on a diagonal line from the portion of the direct current negative pole terminal 27 of the conductive pattern 22a) with electrically conductive adhesive sheet 28. Accordingly, the power semiconductor element 23 is bonded electrically and thermally to the conductive pattern 22a. Practical composition of the electrically conductive adhesive sheet 28, 29 will be explained later.

Each of the power semiconductor element 23 located on the position of the direct current negative pole terminal 27 of the conductive pattern 22a and the direct current negative pole terminal 27, the alternate current terminal 24 and one of the conductive patterns 22a, the power semiconductor element 23 located on the position of another alternate current terminal 24 of the conductive pattern 22a and the alternate current terminal 24, another one of the conductive patterns 22a and the direct current pole terminal 26 are bonded each other with the electrically conductive adhesive sheet 30. Practical composition of the electrically conductive adhesive sheet 30 will be explained later.

The power semiconductor element is shaped in a chip, which is provided with the source electrode 23c and the gate electrode 23b on the upper surface of the chip and the drain electrode on the lower surface of the chip. The power semiconductor element 23 located on the portion of the alternate current terminal 24 of the conductive pattern 22a corresponds to the upper arm side element, and the power semiconductor element 23 located on the portion of the direct current negative pole terminal 27 of the conductive pattern 22a corresponds to the lower arm side element. The gate electrode 23b is connected electrically to the driving circuit substrate connecting terminal 31 , which is bonded to a substrate composing an inverter driving circuit, which is not shown in the figure, with the wire 32.

The driving circuit substrate connecting terminal 31 is a member made of conductive material formed a L-shape, one of the ends is exposed in the case, and another end extends upwards through inner portion of the case 21. One side of the driving circuit substrate connecting terminal 31 is formed in a flat plane which makes the wire 31 possible to form wire-bonding. Another side of the driving circuit substrate connecting terminal 31 is formed in a pin shape which can be inserted into a hole provided to the substrate composing the inverter driving circuit, which is not shown in the figure, The driving circuit substrate connecting terminal 31 is provided to the case by insert-fabrication.

Next, the electrically conductive adhesive sheet 28, 29 shown in FIG. 1 and the electrically conductive adhesive sheet 30 shown in FIG. 2 are explained hereinafter.

The reference number 1 in FIG. 1 and FIG. 2 indicates a substrate. The substrate is composed of metallic foil, which forms electrically, thermally, or both electrically and thermally conductive paths in a direction along the plane of the sheet. The metallic foil is composed of a composite material manufactured by laminating second metallic materials onto both sides of a first metallic material; the metal foil has a coefficient of thermal expansion larger than the coefficient of thermal expansion of the power semiconductor element (2∼4 ×10⁻⁶/K), which is one of the bonded members, and smaller than the coefficient of thermal expansion of the conductive pattern 22a (17∼25 ×10⁻⁶/K), which is another one of the bonded members. That is, the coefficient of thermal expansion of the substrate 1 is in intermediate of the coefficients of thermal expansion of the bonded members.

The first metallic material has a coefficient of thermal expansion smaller than the coefficient of thermal expansion of the second metallic material. In accordance with the present embodiment , an iron-nickel alloy of 35 µm thick containing nickel 42% by weight is used as the first metallic material. In the present embodiment, an example using the iron-nickel alloy containing nickel 42% by weight is explained. However, the present invention is not restricted by this example, and the content of nickel is preferably in the range of 30∼55% by weight. The second metallic material has a volume resistivity smaller than the volume resistivity of the first metallic material. In accordance with the present embodiment, a copper foil of approximately 10 µm thick is used as the second metallic material, and the both sides of the iron-nickel alloy plate are clad with the copper foil. In accordance with the explanation described above, total thickness of the substrate 1 becomes 55 µm, but the present invention is not restricted by this example, and the total thickness of the substrate 1 may preferably be set in the range of several µm to several mm. The case when electricity is flown in a direction along the surface of the sheet, the thickness of the sheet becomes thicker than the case when heat is transferred, and the thickness of the substrate may be controlled corresponding to the flow value of electric current.

A protrusion layer 2 is formed on both sides of the substrate of the electrically conductive adhesive sheet 28, 29 shown in FIG. 1, and on one side of the substrate, which is connecting portion 5 facing to the bonded member (in accordance with the present embodiment, both ends of the substrate), of the electrically conductive adhesive sheet 30 shown in FIG. 2. In the protrusion layer, plural metallic columns 3 are formed on the surface of the substrate 1 in a matrix arrangement with an equal pitch of 200 µm, and it forms electrically, thermally, or both electrically and thermally conductive paths between the substrate 1 and the bonded member, that is, in a direction along the thickness of the sheet. The metallic column 3 is a short cylinder having a circular cross section, which is 100 µm in diameter and 50 µm in length in a direction along the thickness of the sheet, and the metallic column 3 is provided on the surface of the substrate so that top of the column is exposed outside from the resin composition 4 or so that top of the column is extended outside of the resin composition 4. The resin composition 4 is filled into the vacancy among plural metallic columns 3 in the protrusion layer 2. The resin composition 4 is 50 µm thick in a direction along the thickness of the sheet, and it is made of thermosetting polyimide film.

In accordance with the electrically conductive adhesive sheet of the present embodiment shown in FIG. 2, the resin composition is filled into only the bonding portion 5 where the protrusion layer 2 is formed. However, an insulation resin layer may be formed onto a portion other than the bonding portion and surface of the substrate 1 with the aim of ensuring insulation from other circuits. The resin to form the insulation resin layer may be the same resin as the resin composition 4 or other different resin from the resin composition 4.

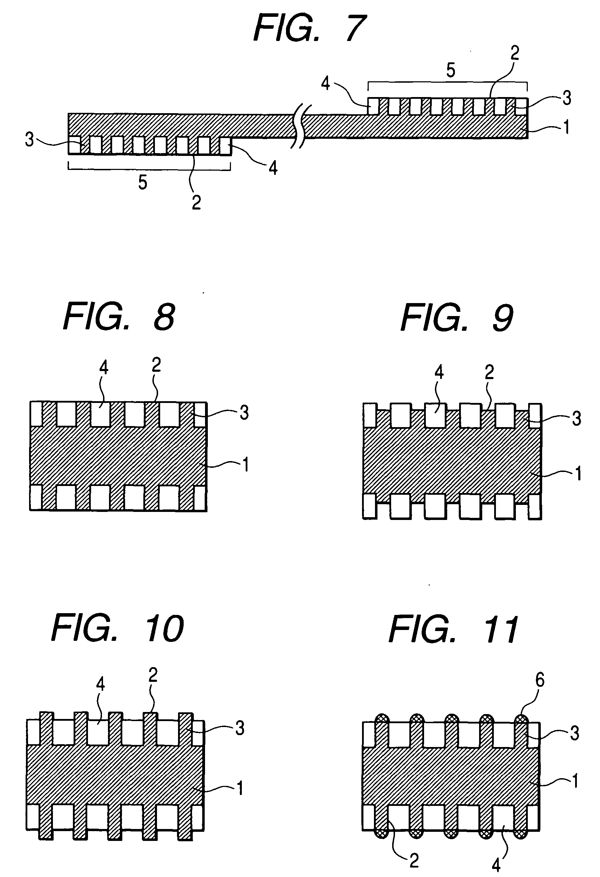

In accordance with the present embodiment, top of the metallic column 3 is exposed outside from the surface of the resin composition 4 or extended outside from outside of the surface of the resin composition 4, as described previously, but there are various methods to realize this matter, and any method may be used. For instance, as shown in FIG. 8, the top of the metallic column 3 may be placed at the same level as the surface of the resin composition 4. Furthermore, as shown in FIG. 9, top of the metallic column is placed at a lower level than the surface of the resin composition 4, and dimples may be formed on the surface of the resin composition 4. Furthermore, as shown in FIG. 10, top of the metallic column is placed at a higher level than the surface of the resin composition 4, and the top of the metallic column 3 may be exposed outside from the surface of the resin composition 4 . If the resin composition 4 shrinks or becomes fluid by heating when a bonding procedure for bonding the bonded members is performed, it can be said that the method to form dimples onto the surface of the resin composition 4 as shown in FIG. 9 may be advantageous. When the top of the metallic column 3 is bonded to the bonded members by welding, soldering, or pressure-bonding, the method to extend the top of the metallic column 3 outside from the surface of the resin composition 4 as shown in FIG. 10 can be said as advantageous.

In accordance with the present embodiment, a short cylinder having a circular cross section was used as the metallic column as mentioned previously, but the column may have a polygonal cross section. In accordance with the present embodiment, the metallic columns were arranged regularly in a matrix with a pitch as mentioned previously, but irregular arrangement is adoptable. In accordance with the present embodiment, the thickness of the protrusion layer 2 was set as 50 µm as mentioned previously, but the thickness is not limited by the present embodiment, and the thickness of the protrusion layer 2 may be set within a range of several microns to several millimeters.

In accordance with the present embodiment, polyimide film was used as the resin composition 4, as mentioned previously, but resins, of which main component is a thermosetting resins such as epoxy resin, phenol resin, and the like, may be useful. Or, resins, of which main component is a thermoplastic resin such as polyamide resin, polyamide-imide resin, polyether-imide resin, and the like, may be useful as the resin composition 4. Or, a mixture of thermosetting resin and thermoplastic resin may be useful as the resin composition 4. A filler such as inorganic filler, glass, and the like may be mixed into the resin composition 4.

The electrically conductive adhesive sheet 28, 29 shown in FIG. 1 of the present embodiment is usable for bonding two bonding members, of which bonding planes are facing each other in a direction along the thickness direction of the sheet such as connection between the power semiconductor element 23 and the conductive pattern 22a, and connection between the conductive pattern 22b and the heat radiation plate 20. The electrically conductive adhesive sheet 30 shown in FIG. 2 of the present embodiment is usable for connecting two bonding members, of which bonding planes are facing in a same direction at a different position each other of a plane in a direction along the plane of the sheet such as connection between the conductive pattern 22a and the direct current positive pole terminal 26 or the alternate current terminal 24, and connection between the power semiconductor element 23 and the direct current negative pole terminal 27 or the alternate current terminal 24. In order to connect two bonding members, of which bonding planes are facing each other at a different position each other of a plane in a direction along the plane of the sheet, one of the protrusion layer 2 provided at both ends of one side of the substrate 1 of the electrically conductive adhesive sheet 30 shown in FIG. 2 is further provided at one end of another side of the substrate 1 as shown in FIG. 7, that is, the electrically conductive adhesive sheet may be formed in a crank-shape.

Next, the manufacturing method of the electrically conductive adhesive sheet is explained hereinafter.

In accordance with the present embodiment, the manufacturing method of the electrically conductive adhesive sheet 28, 29 shown in FIG. 1 is taken as an example for the explanation, but this manufacturing method is applicable to the electrically conductive adhesive sheet 30 shown in FIG. 2 in the same manner.

### First manufacturing step:

Both sides of iron-nickel alloy foil (made by Hitachi Metal Co. :YEF42) containing nickel 42% by weight of 35 µ m thick are electroplated with copper. Accordingly, the substrate 1 made of iron-nickel alloy foil, both sides of which is clad with copper of approximately 10 µm thick, is manufactured.

### Second manufacturing step:

polyimide film (made by Ube Kosan Co. :UPILEX VT) of 50 µm thick is adhered to both sides of the substrate 1, and pressed it with vacuum pressing machine for bonding. Accordingly, a sheet member which is composed of the substrate 1 having a resin layer made of the resin composition 4 on both sides is manufactured.

### Third manufacturing step:

Holes of 100 µm in diameter are formed into all the surface of the resin layer on both sides of the sheet member in directions of length and width with an equal pitch of 200 µm using a UV-YAG type laser boring machine.

### Fourth manufacturing step:

Inner side of the holes of the sheet member is electroplated with copper. Accordingly, the protrusion layer 2, in which top of the metallic column 3 is exposed outside from the surface of the resin composition 4, or top of the metallic column 3 is extended outside from the surface of the resin composition 4, is manufactured, and electrically conductive adhesive sheet of approximately 150 µm thick is obtained.

In accordance with the present embodiment, the protrusion layer 2 was formed by electroplating with copper as mentioned previously, but the present invention is not restricted with this method. Various methods such as a method of etching a part of the substrate 1, a method of sputtering a same or different kind of metal onto the surface of the substrate 1, a method of cladding a same or different kind of metal onto the surface of the substrate 1, are applicable.

Next, the assembling method of electric power converting equipment using the electrically conductive adhesive sheet 28, 29 shown in FIG. 1 and the electrically conductive adhesive sheet 30 shown in FIG. 2 is explained hereinafter.

### First assembling step:

A case 21, in which a heat radiation plate 20, an insulation substrate 22 having metallized conductive pattern 22a , 22b on both sides, a direct current positive pole terminal 26, a direct current negative pole terminal 27, an alternate current terminal 24, and a driving circuit substrate connecting terminal 31 are inserted, and power semiconductor elements 23 are prepared.

### Second assembling step:

The electrically conductive adhesive sheet 29 shown in FIG. 1 is placed onto the heat radiation plate 20, and the insulation substrate 22 is placed onto the electrically conductive adhesive sheet 29 so that the conductive pattern 22b faces downwards. Furthermore, the electrically conductive adhesive sheet 28 shown in FIG. 1 is placed onto the insulation substrate 22 at each of the portions on the one side of the conductive pattern 22a and the direct current negative pole terminal 27 side and on another side of the conductive pattern 22a and the alternate current terminal 24; and the power semiconductor element 23 is placed onto each of the electrically conductive adhesive sheets 28 so that the plane of the drain electrode faces downwards. Under this condition, the piled up members are thermally bonded with pressure by vacuum pressing machine. Accordingly, the resin composition 4 is cured or molten, and the resin composition 4 and the bonding members are bonded in a condition that the surface of the metallic column is contacted with the surface of the bonding members with plane-plane contact, and the bonding members are bonded. The top of the metallic column 3 and the bonded member can be welded by applying ultrasonic wave to a metal at the top of the metallic column and a metal at the bonded member for melting-adhesion during the bonding process. Accordingly, a strong connecting strength can be obtained.

### Third assembling step:

The heat radiation plate 20 is adhered to the case 21 with a silicone adhesive agent (not shown in the figure) .

The protrusion layer 2 on the one side of the electrically conductive adhesive sheet 30 shown in FIG. 2 is placed onto the plane of the source electrode 23c of the power semiconductor element 23, the protrusion layer 2 on another side is placed onto the plane of the direct current negative pole terminal 27, and these members are bonded by a flip chip bonder. Similarly, the protrusion layer 2 on the one side of the electrically conductive adhesive sheet 30 shown in FIG. 2 is placed onto the plane of the source electrode 23c of the power semiconductor element 23, the protrusion layer 2 on another side is placed onto the plane of the alternate current terminal 24, and these members are bonded by a flip chip bonder. Furthermore, the protrusion layer 2 on the one side of the electrically conductive adhesive sheet 30 shown in FIG. 2 is placed onto the plane of the conductive pattern 22a, the protrusion layer 2 on another side is placed onto the plane of the direct current positive pole terminal 6, and these members are bonded by a flip chip bonder. Similarly, the protrusion layer 2 on the one side of the electrically conductive adhesive sheet 30 shown in FIG. 2 is placed onto the plane of the conductive pattern 22a, the protrusion layer 2 on another side is placed onto the plane of the alternate current terminal 24, and these members are bonded by a flip chip bonder.

### Fifth assembling step:

The gate electrode 23b of the power semiconductor element 23 and the driving circuit substrate connecting terminal 31 are bonded with wire 32 to connect the gate electrode 23b of the power semiconductor element 23 with the driving circuit substrate connecting terminal 31 electrically.

### Sixth assembling step:

Silicone gel resin (not shown in the figure) is poured into the case 21, and a cover made of resin (not shown in the figure) is adhered onto the upper opening of the case 21 with an epoxy resin adhesive agent (not shown in the figure) to close the upper opening of the case 21 with the cover made of resin (not shown in the figure).

In accordance with the electrically conductive adhesive sheet of the present embodiment explained above, because metallic foil made of a composite material which is composed of a metal having s small volume resistivity and a metal having a small coefficient of thermal expansion is used as the substrate 1, the volume resistivity of the substrate 1 can be made small as equivalent as conventional metal substrate made of copper, and concurrently, the coefficient of thermal expansion of the substrate 1 can be made smaller than that of conventional metal substrate made of copper. Therefore, the electrically conductive adhesive sheet of the present embodiment can moderate the stress applied to the metallic column 3 owing to the difference in thermal expansion corresponding to the difference in coefficient of thermal expansion of bonded members, for instance, the power semiconductor element 23 and the conductive pattern 22a, and connection reliability can be improved better than ever. Accordingly, in accordance with the electrically conductive adhesive sheet of the present embodiment, even if the electrically conductive adhesive sheet is applied as the bonding member to an equipment which is operated under severe thermal cycles, for instance, an electric power conversion equipment for vehicle which is required to have a long product life over than 15 years, the equipment can maintain the connection reliability for a long time, and the electrically conductive adhesive sheet can contribute to long extension of the product life of the equipment. Furthermore, in the present embodiment, a composite material was used as the substrate 1, but if any single material having a low volume resistivity and a low coefficient of thermal expansion as equivalent to the composite material is available, the single material can be used as the substrate 1. If the electrically conductive adhesive sheet is used as a bonding member aiming only at thermal connection of the bonded member, an iron-nickel alloy containing nickel 30∼55 % by weight can be used as a single material for the substrate 1.

In accordance with the electrically conductive adhesive sheet of the present embodiment, the protrusion layer 2 and the substrate 1 form thermal and electrical conducting paths, and no contact point is formed inside the sheet. Therefore, the same thermal conductivity and volume resistivity as metal can be obtained.

In accordance with the electrically conductive adhesive sheet of the present embodiment, the metallic column 3 can readily be deformed elastically, because the resin composition is filled into the protrusion layer 2. Therefore, in accordance with the electrically conductive adhesive sheet of the present embodiment, the stress generated at bonded boundary plane of the bonded members, for instance, the power semiconductor 23 and the conductive pattern 22a, on account of the difference in thermal expansion corresponding to the difference in their coefficients of thermal expansion, the stress generated at the bonded boundary plane of the power semiconductor element 23 and the electrically conductive adhesive sheet, and the stress generated at the bonded boundary plane of the conductive pattern 22 and the electrically conductive adhesive sheet, can be moderated.

In order to confirm experimentally the advantages of the electrically conductive adhesive sheet of the present embodiment as a bonding member for the equipment under severe thermal cycles, the inventor cut the electrically conductive adhesive sheet obtained in the present embodiment to a sheet of 10 mm X 10 mm, and measured its thermal resistance and electric resistance. As the result, the thermal resistance of the electrically conductive adhesive sheet obtained in the present embodiment was 0.019 (K/W), and electric resistance was 9.2 X 10⁻⁸ (Ω).

A temperature cycle test under an environment of low temperature of -40 °C for 30 minutes and high temperature of 125 °C for 30 minutes was performed for 1000 cycles on the power conversion equipment for vehicle, in which the electrically conductive adhesive sheet of the present embodiment was applied as a bonding member. After the temperature cycle test, the cross section of the sample was observed. As the result, any failure such as wire breakage, peeling, and the like was not observed, and high reliability of the power conversion equipment for vehicle, in which the electrically conductive adhesive sheet of the present embodiment was applied, was confirmed.

### [Embodiment 2]

A method of manufacturing the electrically conductive adhesive sheet, which is the embodiment 2 of the present invention, is explained hereinafter. The composition of the electrically conductive adhesive sheet of the present embodiment is as same as the composition of the electrically conductive adhesive sheet of the embodiment 1. Furthermore, the present embodiment is explained on the manufacturing method of the electrically conductive adhesive sheet having the same structure as the embodiment 1 for example, in which the protrusion layer 2 is provided on both sides of the substrate 1, but the method is applicable to the structure, in which the protrusion layer 2 is provided only on one side of the substrate 1.

### First manufacturing step:

Both sides of iron-nickel alloy foil (made by Hitachi Metal Co. : YEF42) containing Nickel 42% by weight of 35 µ m thick are electroplated with copper. Accordingly, the substrate 1 made of iron-nickel alloy foil, both sides of which is clad with copper of approximately 10 µm thick, is manufactured.

### Second manufacturing step:

Both sides of the substrate is laminated with photosensitive resist to be approximately 50 µm thick, focused with photo-mask, and exposed to light with extra-high pressure mercury lamp. Then, holes of 100 µ m in diameter are formed into all the surface of the photosensitive resist on both sides of the substrate 1 in the directions of length and width with an equal pitch of 200 µm by development.

### Third manufacturing step:

Inner side of the holes of the photosensitive resist is electroplated with copper. Then, the photosensitive resist is peeled off. Accordingly, plural metallic columns 3 are formed on both sides of the substrate 1, and the protrusion layer 2 of approximately 50 µm thick is formed on both sides of the substrate 1.

### Fourth manufacturing step:

Polyimide varnish (made by Ube Kosan Co. : U-Varnish-A) is printed on the protrusion layer 2 formed on both sides of the substrate 1 using metal mask, and it is dried at 130 °C in an oven for 30 minutes. Accordingly, the resin composition 4 is filled into the protrusion layer 2.

### Fifth manufacturing step:

The electrically conductive adhesive sheet of approximately 150 µm thick was manufactured by removing residual of the polyimide varnish at edge of the protrusion layer 2 by plasma washer, and extending or exposing top of the metallic column 3 outside from the surface of the resin composition 4.

The same advantages as the electrically conductive adhesive sheet of the embodiment 1 can be obtained with the electrically conductive adhesive sheet of the present embodiment as explained above.

### [Embodiment 3]

A method of manufacturing the electrically conductive adhesive sheet, which is the embodiment 3 of the present invention, is explained hereinafter. The composition of the electrically conductive adhesive sheet of the present embodiment is as same as the composition of the electrically conductive adhesive sheet of the embodiment 1. Furthermore, the present embodiment is explained on the manufacturing method of the electrically conductive adhesive sheet having the same structure as the embodiment 1 for example, in which the protrusion layer 2 is provided on both sides of the substrate 1, but the method is applicable to the structure, in which the protrusion layer is provided only on one side of the substrate 1.

### First manufacturing step:

Both sides of iron-nickel alloy foil (made by Hitachi Metal Co.: YEF42) containing Nickel 42% by weight of 35 µ m thick are electroplated with copper. Accordingly, the substrate 1 made of iron-nickel alloy foil, both sides of which is clad with copper of approximately 10 µm thick, is manufactured.

### Second manufacturing step:

A sheet member, which is composed of the substrate 1 having a resin layer of the resin composition 4 on both sides, is manufactured by laminating both sides of the substrate with epoxy group insulation resin(made by Asahi Denka Co.: BUR-453S) to be approximately 50 µm thick, and heating and curing with vacuum pressing machine.

### Third manufacturing step:

Holes of 100 µm in diameter are formed into all the surface of the resin layer on both sides of the substrate 1 in the directions of length and width with an equal pitch of 200 µm by UV-YAG laser boring machine.

### Fourth manufacturing step:

The electrically conductive adhesive sheet of approximately 150 µm thick is obtained by electroplating the inner side of the holes of the sheet member with copper in order to form the protrusion layer 2, in which top of the metallic column 3 is extended or exposed outside from the surface of the resin composition 4.

The same advantages as the electrically conductive adhesive sheet of the embodiment 1 can be obtained with the electrically conductive adhesive sheet of the present embodiment as explained above.

### [Embodiment 4]

A composition of the electrically conductive adhesive sheet, which is the embodiment 4 of the present invention, is explained hereinafter referring to FIG. 11. The electrically conductive adhesive sheet of the present embodiment is manufactured by any one of the manufacturing methods explained in the embodiments 1 to 3, and a metallic layer 6 made of nickel and gold is formed at the top of the metallic column 3 composing the protrusion layer 2.

The electrically conductive adhesive sheet of the present embodiment composed of as explained above, is obtained by manufacturing the electrically conductive adhesive sheet by any one of the manufacturing methods explained in the embodiments 1 to 3, and electroless plating the top of the metallic column 3, which composes the protrusion layer 2, with nickel to approximately 5 µm thick, then, electroless plating the top of the metallic column with gold further to form the metallic layer 6 made of nickel and gold at the top of the metallic column 3 which composes the protrusion layer 2.

In accordance with the electrically conductive adhesive sheet of the present embodiment, because the metallic layer 6 made of nickel and gold is formed at the top of the metallic column 3, which composes the protrusion layer 2, the contact resistance at the surface of the bonded members, for instance, at the surface of the power semiconductor element 23 and the top of the metallic layer 6 can be made smaller than any of the electrically conductive adhesive sheet of the embodiments 1 to 3, and thermal conductivity and volume resistivity can be improved further.

In accordance with the present embodiment, the metallic layer 6 was formed by plating, but the present invention is not restricted with this example, and other manufacturing methods such as sputtering, cladding, and the like are applicable. The present embodiment is explained on the case that the metallic layer 6 is formed at the top of the metallic column 3 made of copper. However, when the metallic column 3 is made of iron-nickel alloy, plating with copper is performed first, and then, electroless nickel plating and electroless gold plating are performed. With this method, a gold plated layer can be provided at the outermost layer of the top of the metallic column 3, and the contact resistance between bonded members, for instance, the contact resistance between the surface of power semiconductor element 23 and the top of the metallic layer 6 can be made small. When the metallic column 3 is made of a metal other than aluminum, aluminum is provided at the top of the metallic column 3 by sputtering, and ultrasonic wave is applied in a pressurizing-heating process for bonding the bonding members, for instance, bonding the power semiconductor element 23 and the electrically conductive adhesive sheet, welding of aluminum pad of the power semiconductor element 23 to the top of the metallic column 3 can be performed favorably, and a high bonding strength can be obtained.

### [Embodiment 5]

The electrically conductive adhesive sheet, which is the embodiment 5 of the present invention, is explained hereinafter. The electrically conductive adhesive sheet of the present embodiment is manufactured by any one of the manufacturing methods explained in the embodiments 1 to 3, and a metallic layer 6 made of tin is formed at the top of the metallic column 3 composing the protrusion layer 2. The electrically conductive adhesive sheet of the present embodiment composed of as explained above, is obtained by manufacturing the electrically conductive adhesive sheet by any one of the manufacturing methods explained in the embodiments 1 to 3, and electroplating the top of the metallic column 3, which composes the protrusion layer 2, with a tin- zinc alloy to approximately 10 µm thick to form the metallic layer 6 made of the tin-zinc alloy at the top of the metallic column 3 which composes the protrusion layer 2.

In accordance with the electrically conductive adhesive sheet of the present embodiment, the same advantages as the previous embodiments can be obtained.

The present embodiment is explained on the case that the metallic layer 6 made of the tin-zinc alloy is formed at the top of the metallic column 3 made of copper, but another metallic layer 6 which is made of electroless tin and silver may be formed instead at the top of the metallic column 3. That is, electroless plating the top of the metallic column 3 with tin, and then, plating the top of the metallic column 3 with silver to form the metallic layer 6 at the top of the metallic column 3. In accordance with forming the metallic layer 6 composed as explained above, when the bonding members are bonded, the metallic layer 6 composed of the electroless tin and silver is molten, and the top of the metallic column 3 can be soldered to a metallic plane of the bonding member. Accordingly, a high bonding strength can be obtained.

Without describing every possible configuration or modification in detail, parts and features of the above mentioned described embodiments 1-5 may be combined or exchanged with each other, according to the understanding of an expert skilled in the art, for providing further embodiments optimized for the respective application.
Explanation of the reference signs
1...SUBSTRATE, 2...PROTRUSION LAYER, 3...METALLIC COLUMN, 4...RESIN COMPOSITION, 5...METALLIC LAYER.

## Claims

1. Electrically conductive adhesive sheet composed of at least two bonded members, each of which has a different coefficient of thermal expansion each other, which are connected electrically, thermally, or both electrically and thermally by bonding: comprising
a substrate (1),
a protrusion layer (2) formed on one side or both sides of said substrate (1), and
a resin composition (4) filled in said protrusion layer (2), wherein
said substrate (1) is composed of a metallic foil, which forms electrically, thermally, or both electrically and thermally conductive paths in a direction along the surface of said adhesive sheet, and
said substrate (1) has a coefficient of thermal expansion between the coefficient of thermal expansion of one of said at least two bonded members and the coefficient of thermal expansion of another one of said bonded members;
said protrusion layer (2) is provided with plural metallic columns (3) to form electrically, thermally, or both electrically and thermally conductive paths between said at least two bonded members and said substrate (1), and said plural metallic columns (3) are formed on a surface of said substrate (1) so that a top of said columns (3) is exposed 0235-61.789EP/TE-gla
outside from the surface of said resin composition (4); and
said resin composition (4) adheres said at least two bonded members so that said at least two bonded members are connected in a condition that said plural metallic columns (3) are contacted with said at least two bonded members.

2. Electrically conductive adhesive sheet according to claim 1, **characterized in that**
said metallic foil is made of a composite metallic material composed by laminating second metallic material onto both sides of a first metallic material;
said first metallic material has a coefficient of thermal expansion smaller than the coefficient of thermal expansion of said second metallic material; and
said second metallic material has a volume resistivity smaller than the volume resistivity of said first metallic material.

3. Electrically conductive adhesive sheet according to claim 2, **characterized in that**
said first metallic material is an iron-nickel alloy containing nickel from 30% to 55% by weight, and said second metallic material is copper.

4. Electrically conductive adhesive sheet according to at least one of claims 1-3, **characterized in that**
a metallic layer made of any one of copper, nickel, gold, silver, tin, and aluminum as a main component is provided at the top of said metallic column (3).

5. Electrically conductive adhesive sheet provided at an electrical power conversion equipment for a vehicle:
the electrical power conversion equipment converts direct current power supplied from a battery to alternate current power by a conversion circuit composed of semiconductor elements (23), and the converted alternate current power is supplied to an engine;
which is a bonding member of electrical power conversion equipment for mounting on said vehicle applying at least for bonding said semiconductor elements (23) to electrically conductive members connected electrically to a battery mounted on said vehicle, and for bonding said semiconductor elements (23) to electrically conductive members connected electrically to a motor;
which comprises
a substrate (1),
a protrusion layer (2) formed on both sides or one side of said substrate (1), and
a resin composition (4) filled in said protrusion layer,
wherein
said substrate (1) is made of a composite metallic foil composed by laminating second metallic material on both sides of a first metallic material, forming an electrically and thermally conductive path in a direction along the surface of said sheet, having a coefficient of thermal expansion between the coefficients of thermal expansion of said semiconductor elements and said electrically conductive members connected electrically to a battery mounted on said vehicle, or said electrically conductive members connected electrically to said motor;
said first metallic material has a coefficient of thermal expansion lower than the coefficient of thermal expansion of said second metallic material;
said second metallic material has a volume resistivity smaller than the volume resistivity of said first metallic material;
said protrusion layer (2) is provided with plural metallic columns to form electrically and thermally conductive path between said substrate (1) and said electrically conductive member connected electrically to a battery mounted on vehicle, between said substrate (1) and said electrically conductive member connected electrically to said motor, and between said substrate (1) and said semiconductor element (23) ;
said plural metallic columns (3) are formed on a surface of said substrate (1) so that a top of said columns (3) is exposed outside from the surface of said resin composition (4); and
said resin composition (4) adheres said semiconductor element (23) to said electrically conductive member connected electrically to a battery mounted on said vehicle, and adheres said semiconductor element to said electrically conductive member connected electrically to said motor, by bonding said electrically conductive member connected electrically to a battery mounted on said vehicle, said electrically conductive member connected electrically to said motor, and said semiconductor element (23) to each other in a condition that said plural metallic columns (3) are contacted with said electrically conductive member connected electrically to said battery mounted on said vehicle, said electrically conductive member connected electrically to said motor, and said semiconductor element (23) to each other.

6. Electrically conductive adhesive sheet according to claim 5, **characterized in that**
said first metallic material is an iron-nickel alloy containing nickel from 30% to 55% by weight, and said second metallic material is copper.

7. Electrically conductive adhesive sheet according to claim 5, **characterized in that**
a metallic layer made of any one of copper, nickel, gold, silver, tin, and aluminum as a main component is provided at the top of said metallic column.

8. A manufacturing method of electrically conductive adhesive sheet comprising the steps of:
forming a substrate (1) by cladding both sides of a second metallic material having a coefficient of thermal expansion smaller than the coefficient of thermal expansion of a first metallic material with said first metallic material having a volume resistivity smaller than the volume resistivity of said second metallic material;
forming a resin layer with a resin composition (4) at both sides or one side of said substrate (1);
forming plural holes with a designated pitch at said resin layer; and
electroplating said plural holes to form a protrusion layer (2) at both sides or one side of said substrate (1) by forming plural metallic columns (3) on a surface of said substrate (1) so that top of said metallic column (3) is exposed outside from a surface of said resin layer.

9. Manufacturing method of electrically conductive adhesive sheet according to claim 7, **characterized by** further comprising the step of:
forming a metallic layer made of any one of copper, nickel, gold, silver, tin, and aluminum as a main component at the top of said plural metallic column, after forming said protrusion layer.

10. Manufacturing method of electrically conductive adhesive sheet comprising the steps of:
forming a substrate (1) by cladding both sides of a second metallic material having a coefficient of thermal expansion smaller than the coefficient of thermal expansion of a first metallic material with said first metallic material having a volume resistivity smaller than the volume resistivity of said second metallic material;
adhering a pattern member for plating onto both sides or one side of said substrate (1);
forming plural holes with a designated pitch at said pattern member for plating;
peeling off said pattern member for plating after electroplating said plural holes to form a protrusion layer (2) at both sides or one side of said substrate (1) by forming plural metallic columns (3) on a surface of said substrate (1);
forming a resin layer at both sides or one side of said substrate (1) by filling said protrusion layer (2) with a resin composition (4); and
manufacturing a surface of said resin layer so that a top of said plural metallic column (3) is exposed outside from the surface of said resin layer.

11. Manufacturing method of electrically conductive adhesive sheet according to claim 9 or 10, **characterized by** further comprising the step of:
forming a metallic layer made of any one of copper, nickel, gold, silver, tin, and aluminum as a main component at the top of said plural metallic columns (3) which are exposed outside from said resin layer after manufacturing said surface of said resin layer.

12. An electric power conversion equipment, which supplies electric power to a motor after converting direct current power supplied from a battery to alternate current power so as to control motor driving, comprising,
a heat sink (20) cooled by cooling medium;
an insulated substrate (22) mounted on said heat sink; plural semiconductor elements (23) mounted on said insulated substrate (22);
plural electrically conductive members at input side which receive output from a battery mounted on said vehicle; and
plural electrically conductive members at output side which receive output from said semiconductor elements (23); wherein
plural semiconductor elements (23) compose plural upper-side arm semiconductor elements and plural lower-side arm semiconductor elements;
said plural upper-side arm semiconductor elements and plural lower-side arm semiconductor elements are connected electrically in a bridge shape so as to form a bridge circuit (160) for converting direct current power supplied from a battery mounted on vehicle to alternate current power;
plural electrically conductive patterns are provided at both sides of said insulated substrate (22); and an electrically conductive sheet (28,29,30) is applied at least for connecting said plural upper-side arm semiconductor elements with said electrically conductive pattern which corresponds to each of said plural upper-side arm semiconductor elements, and for connecting said plural lower-side arm semiconductor elements with said electrically conductive pattern which corresponds to each of said plural lower-side arm semiconductor elements, respectively;
further wherein,
said electrically conductive sheet (28,29,30)
comprises, a substrate (1), protrusion layers (2) formed at both sides or one side of said substrate (1), and
resin composition (4) filled into said protrusion layer (2);
further wherein
said substrate (1) is made of metallic foil, forming electrically and thermally conductive path in a direction along the surface of said sheet (28,29,30), having a coefficient of thermal expansion between the coefficients of thermal expansion of said electrically conductive pattern corresponding to each of said plural upper-side arm semiconductor elements, or the coefficients of thermal expansion of said electrically conductive pattern corresponding to each of said plural lower-side arm semiconductor elements, and the coefficients of thermal expansion of said semiconductor element (23);
said protrusion layer (2) is provided with plural metallic columns (3) forming electrically and thermally conductive paths between said substrate (1) and said electrically conductive pattern corresponding to each of said plural upper-side arm semiconductor elements, between said substrate (1) and said electrically conductive pattern corresponding to each of said plural lower-side arm semiconductor elements, and between said plural semiconductor elements and said substrate (1);
said plural metallic columns (3) are provided at surface of said substrate (1) so that a top of said metallic column (3) is exposed outside from a surface of said resin composition (4); and
said resin composition (4) adheres said electrically conductive pattern corresponding to each of said plural upper-side arm semiconductor elements, said electrically conductive pattern corresponding to each of said plural lower-side arm semiconductor elements, and said semiconductor elements to each other in a condition that said plural metallic columns (3) are contacted with said electrically conductive pattern corresponding to each of said plural upper-side arm semiconductor elements, said electrically conductive pattern corresponding to each of said plural lower-side arm semiconductor elements, and said semiconductor elements, to connect said plural upper-side arm semiconductor elements to said electrically conductive pattern corresponding to each of said upper-side arm semiconductor elements, and said plural lower-side arm semiconductor elements to said electrically conductive pattern corresponding to each of said lower-side arm semiconductor elements to each other.

13. Electric power conversion equipment according to claim 11 or 12, **characterized in that**
said metallic foil is made of a composite metallic material
composed by laminating a second metallic material on both sides of a first metallic material,
said first metallic material has a coefficient of thermal expansion lower than the coefficient of thermal expansion of said second metallic material; and
said second metallic material has a volume resistivity smaller than the volume resistivity of said first metallic material.

14. Electric power conversion equipment according to claim 12 or 13, **characterized in that**
said first metallic material is an iron-nickel alloy containing nickel from 30% to 55% by weight, and said second metallic material is copper.

15. Electric power conversion equipment according to claim 11, **characterized in that**
a metallic layer made of any one of copper, nickel, gold, silver, tin, and aluminum as a main component is provided at the top of said metallic column (3).

16. Electric power conversion equipment according to at least one of claims 11-15, **characterized in that**
said electrically conductive adhesive sheet is provided for connecting said heat sink (20) with said electrically conductive pattern on said insulated substrate (22), and heat generated at the semiconductor elements (23) and transmitted from said insulated substrate (22) via said electrically conductive pattern is conducted thermally to said heat sink (20).

17. Electric power conversion equipment according to at least one of claims 11-16, **characterized in that**
said electrically conductive adhesive sheet is provided for;
adhering said plural upper-side arm semiconductor elements with said input side electrically conductive member corresponding to each of said plural upper-side arm semiconductor elements,
adhering said plural upper-side arm semiconductor elements with said output side electrically conductive member corresponding to each of said plural upper-side arm semiconductor elements,
adhering said electrically conductive pattern corresponding to each of said plural upper-side arm semiconductor elements with said output side electrically conductive member corresponding to each of said plural upper-side arm semiconductor elements, and
adhering said electrically conductive pattern corresponding to each of said plural lower-side arm semiconductor elements with said input side electrically conductive member corresponding to each of said plural lower-side arm semiconductor elements; and further provided for;
connecting electrically said plural upper-side arm semiconductor elements with said input side electrically conductive member corresponding to each of said plural upper-side arm semiconductor elements,
connecting electrically said plural upper-side arm semiconductor elements with said output side electrically conductive member corresponding to each of said plural upper-side arm semiconductor elements,
connecting electrically said electrically conductive pattern corresponding to each of said plural upper-side arm semiconductor elements with said output side electrically conductive member corresponding to each of said plural upper-side arm semiconductor elements, and
connecting electrically said electrically conductive pattern corresponding to each of said plural lower-side arm semiconductor elements with said input side electrically conductive member corresponding to each of said plural lower-side arm semiconductor elements.
